# EUROPEAN PATENT APPLICATION

(11) **EP 2 190 182 A1**
(43) Date of publication of application: **26.05.2010**
(21) Application number: 08832711.9
(22) Date of filing: 09.09.2008
(51) Int. Cl.: H04N 5/18

(54) **VIDEO SIGNAL PROCESSING DEVICE**

(30) Priority: 18.09.2007 JP 2007241028
(71) Applicant: Panasonic Corporation, Kadoma-shi Osaka 571-8501 (JP)
(72) Inventor: KITANO, Katsuyuki, Osaka-shi, Osaka 540-6207 (JP); KAGEYAMA, Atsuhisa, Osaka-shi, Osak 540-6207 (JP)
(74) Representative: Grünecker, Kinkeldey, Stockmair & Schwanhäusser Anwaltssozietät
(86) International application number: PCT/JP2008/002491
(87) International publication number: WO 2009/037811

(57) **Abstract**

In a video signal processor (10), a video signal is given to a video input terminal (101) via a coupling capacitor (200). A clamp circuit (104) clamps the video signal input via the video input terminal (101). A format detector section (105) detects a format of the video signal. A controller section (107) changes power supply capability of the clamp circuit (104) according to a detection result of the format detector section (105).

## Description

### TECHNICAL FIELD

The present disclosure relates to a video signal processor, and more particularly relates to a clamp technique for video signals.

### BACKGROUND ART

When an external analog video signal such as a composite signal, a Y/C signal and the like is processed by a video signal processor, a video signal AC coupled by a coupling capacitor has to be input to the video signal processor. Due to AC coupling, a difference in DC level between a video signal to be input to the video signal processor and an original signal is generated. To correct the difference, in general, sync tip clamp or pedestal clamp is performed in a horizontal blanking period of the video signal.

Disadvantageously, clamping of a video signal is affected by changes in power supply voltage and the like. To cope with this, in some techniques, highly accurate clamping is realized by performing, based on an error of a pedestal level of a clamped video signal from a reference level, feedback control of a current amount for clamp operation (see, for example, Patent Document 1).
Patent Document 1: Japanese Published Patent Application No. 2000-278132

### DISCLOSURE OF THE INVENTION

### PROBLEMS WHICH THE INVENTION IS TO SOLVE

Various formats of video signals exist and, as image quality increases, a horizontal synchronizing frequency increases. For example, a horizontal synchronizing frequency of a signal of a 480i (525i) format which is currently a mainstream format for analog broadcasting is 15.75 kHz and, in contrast, the horizontal synchronizing frequency of a 1080p signal which is a so-called full spec high resolution digital signal is 4 times or more as high as that of the 480i signal, i.e., is 67.5 kHz.

As the horizontal synchronizing frequency increases, a horizontal blanking period is shortened. Therefore, a sufficient amount of charges can not be charged in a coupling capacitor by a clamp. Specifically, a feedback system of a clamp can not track a video signal. As a result, a pedestal level of the video signal is not stabilized, and thus, unevenness of display luminance and the like might be caused.

In view of the above-described problems, the present invention has been developed to achieve highly accurate clamping of a high speed video signal.

### SOLUTION TO THE PROBLEMS

Means developed to solve the above-described problems according to the disclosure of the present invention, as a video signal processor, includes a video input terminal to be connected to a coupling capacitor to which a video signal is given, a clamp circuit for clamping the video signal input via the video input terminal, a format detector section for detecting a format of the video signal, and a controller section for changing power supply capability of the clamp circuit according to a detection result of the format detector section. With this configuration, the power supply capability of the clamp circuit is changed according to the format of the video signal. Therefore, in the case where high speed video signal is input, the coupling capacitor can be charged/discharged to a desired voltage in a short time by increasing the power supply capability of the clamp circuit. This allows high accuracy clamping capable of tracking a high speed video signal.

Specifically, the above-described signal processor further includes: an A/D converter for performing A/D conversion of the video signal input via the video input terminal; and a level comparator for comparing an output value of the A/D converter to a reference value. Alternatively, the above-described signal processor further includes: a variable gain amplifier for amplifying the video signal input via the video input terminal; and a level comparator for comparing the amplified video signal to a reference value. The controller section controls, according to a comparison result of the level comparator, whether or not power supply by the clamp circuit is performed.

Moreover, specifically, the clamp circuit includes a variable current source and a switch for switching electrical connection of the variable current source with the video input terminal between a connected state and an unconnected state. Also, the controller section performs switching control of the switch according to a comparison result of the level comparator and changes a current amount of the variable current source according to a format of the video signal indicated by a detection result of the format detector section.

Preferably, the controller section further changes power supply capability of the clamp circuit according to a comparison result of the level comparator. Thus, fluctuations in clamp level caused by changes in power supply voltage and the like can be finely adjusted, thereby allowing clamping of the video signal with increased accuracy.

Specifically, the clamp circuit includes a plurality of variable current sources and a plurality of switches for switching electrical connection of each of the plurality of variable current sources with the video input terminal between a connected state and an unconnected state. The controller section performs switching control of the plurality of switches according to an error from the reference value, indicated by the comparison result of the level comparator, and changes current amounts of the plurality of variable current sources according to a format of the video signal indicated by a detection result of the format detector section.

Preferably, the plurality of variable current sources supply currents having different magnitudes from one another. Thus, power supply can be controlled more precisely.

### EFFECTS OF THE INVENTION

As described above, according to the disclosure of the present invention, a high speed video signal can be clamped with high accuracy.

### BRIEF DESCRIPTION OF THE DRAWINGS

[FIG. 1] FIG. 1 is a block diagram illustrating a configuration of a video signal processor according to a first embodiment of the present invention.
[FIG. 2] FIG. 2 is a circuit diagram of a clamp circuit.
[FIG. 3] FIG. 3 is a block diagram illustrating a configuration of a video signal processor according to a second embodiment of the present invention.

### EXPLANATION OF REFERENCE NUMERALS

- 10: Video signal processor
- 101: Video input terminal
- 102: A/D converter
- 104: Clamp circuit
- 1041: Variable current sources
- 1042: Switches
- 105: Format detector section
- 106: Level comparator
- 107: Controller section
- 108: Variable gain amplifier

### BEST MODE FOR CARRYING OUT THE INVENTION

Hereinafter, the best mode for carrying out the present invention will be described with reference to the accompanying drawings.

### (First Embodiment)

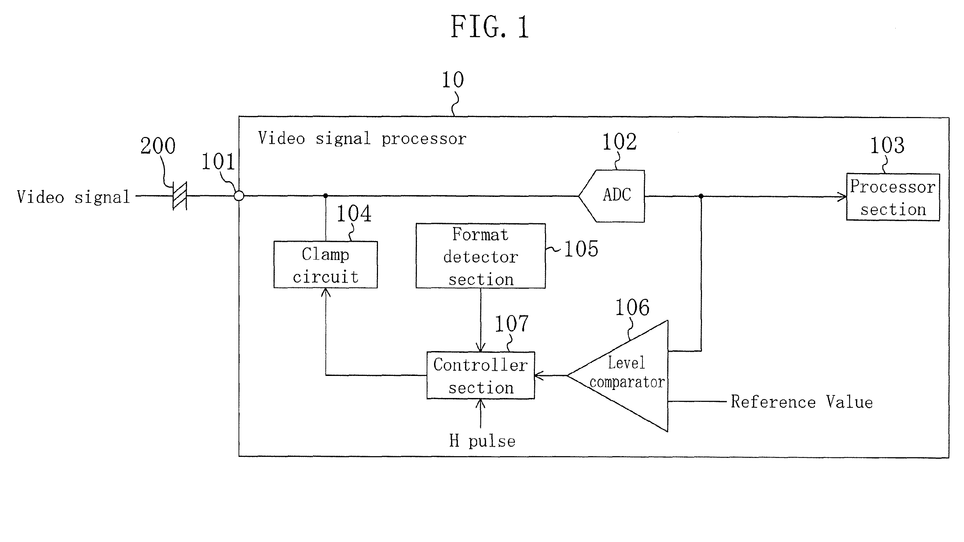

FIG. 1 is a block diagram illustrating a configuration of a video signal processor according to a first embodiment. The video signal processor 10 can be implemented as a single semiconductor chip. A video signal is input to a video input terminal 101 provided in the video signal processor 10 via a coupling capacitor 200. An A/D converter (ADC) 102 performs A/D conversion of the video signal input via the video input terminal 101. A processor section 103 performs various kinds of processing to the video signal converted to a digital value.

A clamp circuit 104 is connected to a video input terminal 101. The coupling capacitor 200 is charged/discharged due to supply of a current from the clamp circuit 104. By adjusting a voltage of the coupling capacitor 200, a video signal to be input to the video signal processor 10 is clamped so as to be within a dynamic range of the A/D converter 102.

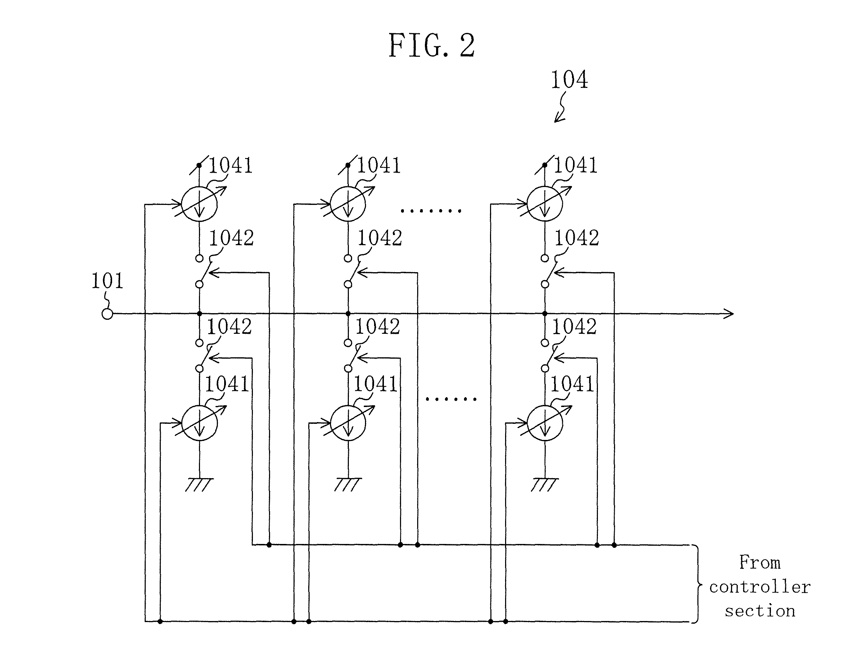

FIG. 2 is a circuit diagram of the clamp circuit 104. The clamp circuit 104 includes a plurality of variable current sources 1041, and a plurality of switches 1042 for switching electrical connection of each of the plurality of variable current sources 1041 with the video input terminal 101 between a connected state and an unconnected state. Specifically, the clamp circuit 104 includes the variable current sources 1041 at both of a source side and a sink side with respect to the video input terminal 101 to allow charging/discharging of the coupling capacitor 200 via video input terminal 101. Respective supply currents of the variable current sources 1041 may be the same or may be different from one another. In the former case, power supply control can be performed in a plurality of stages corresponding to the number of the variable current sources 1041 at the source side or the sink side. In the latter case, power supply control can be performed in a larger number of stages than the number of stages in the former case, i.e., 2ⁿ stages (where n is the number of the variable current sources 1041 at the source side or the sink side) at most.

Referring back to FIG. 1, the format detector section 105 detects a format of the video signal input to the video signal processor 10. Specifically, the format detector section 105 detects a horizontal synchronizing signal included in the video signal, calculates a frequency of the horizontal synchronizing signal, and detects a format of the video signal, based on the calculated frequency. For example, if the horizontal synchronizing frequency is 15.75 kHz, the format of the video signal can be specified as 480i (525i), if the horizontal synchronizing frequency is 31.5 kHz, the format can be specified as 480p (525p), if the horizontal synchronizing frequency is 33.7 kHz, the format can be specified as 1080i (1125i), if the horizontal synchronizing frequency is 45 kHz, the format can be specified as 720p (750p), and if the horizontal synchronizing frequency is 67.5 kHz, the format can be specified as 1080p (1125p).

The level comparator 106 compares an output value of the A/D converter 102 to a reference value. As the reference value, a value corresponding to a pedestal level, or a value corresponding to a sync tip level is input. In the former case, the clamp circuit 104 operates as a pedestal clamp, and in the latter case, the clamp circuit 104 operates as a sync tip clamp.

The controller section 107 controls the clamp circuit 104 according to outputs of the format detector section 105 and the level comparator 106. This control is performed for each horizontal blanking period of the video signal, based on a given horizontal synchronizing signal (H pulse).

Specifically, the controller section 107 performs switching control of each of the switches 1042 (see FIG. 2) in the clamp circuit 104 according to an error of an output value of the A/D converter 102 from the reference value, indicated by a comparison result of the level comparator 106. When the error is larger, the controller section 107 switches more of switches 1042 to a conduction state, or switches, to a conduction state, the switch 1042 connected to the variable current source 1041 which supplies a larger current. Thus, fluctuations in clamp level caused by changes in power supply voltage and the like can be finely adjusted, thereby allowing highly accurate clamping of the video signal.

The controller section 107 changes a current amount of each of the variable current sources 1041 (see FIG. 2) in the clamp circuit 104 according to the format of the video signal indicated by a detection result of the format detector section 105. Specifically, the current amount of each of the variable current sources 1041 is set so that the higher the horizontal synchronizing frequency of the format is, the larger the current amount of each of the variable current sources 1041 is. Thus, the coupling capacitor 200 is charged/discharged by a large amount of current in a limited period (horizontal blanking period), so that clamping capable of tracking a high speed video signal such as a 1080p signal can be performed.

Based on the above, according to the present embodiment, a high speed video signal such as a full spec high resolution digital signal can be clamped with high accuracy. Thus, a good processing result for the high speed video signal can be achieved.

### (Second Embodiment)

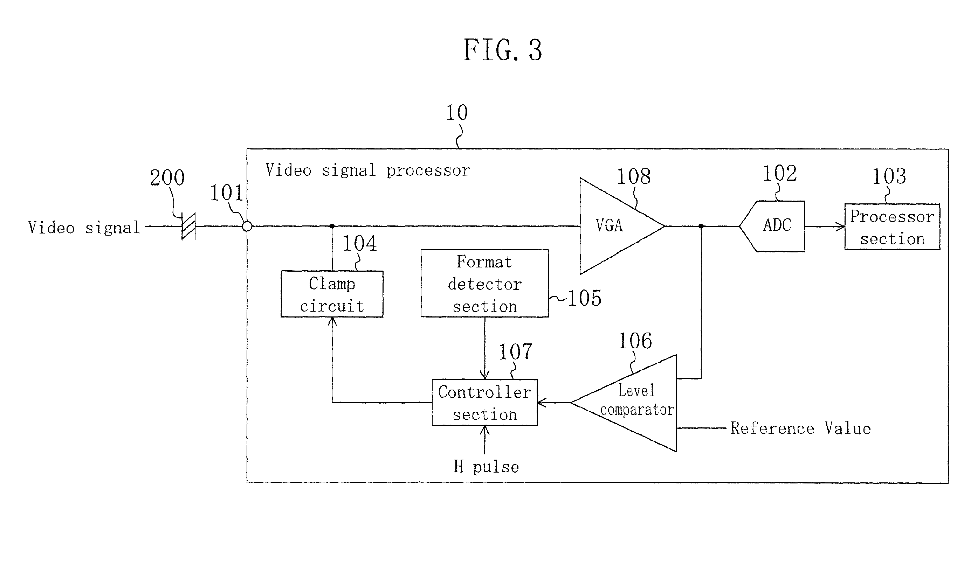

FIG. 3 is a block diagram illustrating a configuration of a video signal processor according to a second embodiment. A video signal processor 10 of this embodiment has a configuration obtained by adding a variable gain amplifier (VGA) 108 in a previous stage of the A/D converter 102 in the video signal processor 10 of the first embodiment. The variable gain amplifier 108 performs gain adjustment so that a video signal to be input to the A/D converter 102 is within a predetermined dynamic range. The level comparator 106 compares the video signal amplified by the variable gain amplifier 108 to a reference value. The video signal processor 10 can be also implemented as a single semiconductor chip. According to the second embodiment described above, a high speed video signal can be clamped with high accuracy.

Note that in both of the first and second embodiments, when fine adjustment of fluctuation in clamp level is not necessary, the clamp circuit 104 may be formed of a single variable current source 1041 and a corresponding switch 1042. Thus, a clamp which has a smaller circuit size and is capable of tracking the high speed video signal can be achieved.

### INDUSTRIAL APPLICABILITY

A video signal processor according to the present invention can clamp a high speed video signal with high accuracy and, therefore, is useful for a television receiver, an optical disc recorder, and the like which deal with a full spec high resolution digital signal.

## Claims

1. A video signal processor comprising:
a video input terminal to be connected to a coupling capacitor to which a video signal is given;
a clamp circuit for clamping the video signal input via the video input terminal;
a format detector section for detecting a format of the video signal; and
a controller section for changing power supply capability of the clamp circuit according to a detection result of the format detector section.

2. The video signal processor of claim 1, further comprising:
an A/D converter for performing A/D conversion of the video signal input via the video input terminal; and
a level comparator for comparing an output value of the A/D converter to a reference value,
wherein the controller section controls, according to a comparison result of the level comparator, whether or not power supply by the clamp circuit is performed.

3. The video signal processor of claim 1, further comprising:
a variable gain amplifier for amplifying the video signal input via the video input terminal; and
a level comparator for comparing the amplified video signal to a reference value,
wherein the controller section controls, according to a comparison result of the level comparator, whether or not power supply by the clamp circuit is performed.

4. The video signal processor of any one of claims 2 and 3, wherein the clamp circuit includes a variable current source and
a switch for switching electrical connection of the variable current source with the video input terminal between a connected state and an unconnected state, and
the controller section performs switching control of the switch according to a comparison result of the level comparator and changes a current amount of the variable current source according to a format of the video signal indicated by a detection result of the format detector section.

5. The video signal processor of any one of claims 2 and 3, wherein the controller section further changes power supply capability of the clamp circuit according to a comparison result of the level comparator.

6. The video signal processor of claim 5, wherein the clamp circuit includes a plurality of variable current sources and
a plurality of switches for switching electrical connection of each of the plurality of variable current sources with the video input terminal between a connected state and an unconnected state, and
the controller section performs switching control of the plurality of switches according to an error from the reference value, indicated by the comparison result of the level comparator, and changes current amounts of the plurality of variable current sources according to a format of the video signal indicated by a detection result of the format detector section.

7. The video signal processor of claim 6, wherein the plurality of variable current sources supply currents having different magnitudes from one another.
